Europäisches Patentamt

(19) European Patent Office

Office européen des brevets

(11) **EP 0 660 805 B1**

(12) **EUROPEAN PATENT SPECIFICATION**

(45) Date of publication and mention
of the grant of the patent:
**21.11.2001 Bulletin 2001/47**

(21) Application number: **93922223.8**

(22) Date of filing: **15.09.1993**

(51) Int Cl.$^7$: **C02F 1/66**

(86) International application number:
**PCT/US93/08785**

(87) International publication number:
**WO 94/06718 (31.03.1994 Gazette 1994/08)**

(54) **METHOD OF CLEANING WASTE WATER AND RECOVERY OF CONTAMINANTS THEREFROM**

METHODE ZUR REINIGUNG VON ABWASSER UND ZUR RÜCKGEWINNUNG VON
VERUNREINIGUNGEN DARAUS

PROCEDE D'EPURATION D'EAUX RESIDUAIRES ET DE RECUPERATION DE CONTAMINANTS
CONTENUS DANS LES EAUX RESIDUAIRES

(84) Designated Contracting States:
**AT BE CH DE DK ES FR GB GR IE IT LI LU MC NL
PT SE**

(30) Priority: **17.09.1992 US 946762
01.04.1993 US 41789
01.04.1993 US 41830
01.04.1993 US 41794
14.07.1993 US 92741
14.07.1993 US 92392
13.09.1993 US 120175**

(43) Date of publication of application:
**05.07.1995 Bulletin 1995/27**

(73) Proprietor: **Coates Lorilleux S.A.
92800 Puteaux (FR)**

(72) Inventor: **PENNAZ, Thomas, J.
Brooklyn Park, MN 55443 (US)**

(74) Representative: **Strehl Schübel-Hopf & Partner
Maximilianstrasse 54
80538 München (DE)**

(56) References cited:
**WO-A-91/16206          US-A- 4 173 532
US-A- 4 260 491          US-A- 5 201 943**

**Description**

**BACKGROUND OF THE INVENTION**

**1. Field of the Invention**

The present invention relates generally to the field of waste water treatment and more particularly to a method of cleaning waste water containing contaminants and the recovery of such contaminants therefrom. The present invention is applicable to lithographic processes, in which the coating composition is water insoluble at first pH levels and water soluble or washable at second pH levels.

**2. Summary of the Prior Art**

Water treatment in general has grown significantly over the past several years. Treatment methods which result in clean water with minimal chemical or energy input are highly desirable. This is particularly true with industrial waste water effluents containing contaminants resulting from the clean up of various coating processes including lithographic or other ink printing processes and paint or varnish application processes. Waste water effluents from such processes often contain organic wash solvents which are needed to clean up application or processing equipment and tools. The laundering of shop towels and other cleaning aids containing such contaminants and organic wash solvents are also a source of pollution since the laundering medium containing such contaminants is commonly disposed of into the sewer system.

In a lithographic printing process which utilizes both an oil based or water insoluble ink composition and an aqueous fountain solution, printing plates and/or inks need to be periodically changed as one job is completed and another started. Whenever this occurs, the blanket cylinder and/or the entire print train including the application rollers, the print plate, etc. must be cleaned. Such cleaning is commonly accomplished using organic or other non aqueous wash solvents which dissolve the ink for removal. This creates a waste solution comprised of the organic or other non aqueous wash solvent and the dissolved contaminant as well as shop towels saturated with such materials.

Such a clean up process gives rise to several sources of both air and water pollution. First, many of the wash solvents needed to acceptably clean the oil based or water insoluble inks or other coating materials contain various volatile organic compounds (VOCs) which are ultimately dispersed into the atmosphere. Secondly, the organic or other non aqueous wash solvents and the dissolved contaminants cannot be discharged into the sewer system without extensive and costly processing and separation of the contaminants. In fact, many are considered hazardous wastes whose disposal is tightly controlled. Thirdly, the laundering of shop towels or other clean up aids and materials results in laundry waste water containing finely dispersed particles of the wash solvents and coating composition contaminant which are difficult to separate through common filtration. Although technology such as reverse osmosis, distillation or other membrane processes will, in theory, function to separate the finely dispersed wash solvent and contaminant particles from the laundry waste water, such processes are energy intensive and require substantial maintenance and upkeep. As a consequence, few industries are able to economically clean such waste water and most continue to discharge such untreated water to the sewer system. The Clean Water Act and various other state and federal legislation, however, will force those responsible for polluting discharges to treat the effluent and to remove the contaminants regardless of treatment costs. As an alternative, many printers have gone to disposable towels which create disposal problems of their own.

Similar disposal and pollution problems exist for non-lithographic ink compositions as well as various water insoluble paint, varnish and other coating compositions.

Accordingly, a need exists for a method of cleaning waste water and recovering the contaminants therefrom. More particularly, a need exists for a method of cleaning waste water from lithographic processes. A need also exists for a method of recovering such contaminants from the waste water and from laundering solutions used to clean shop towels and other clean up aids.

WO 91/16206 discloses an intaglio printing process wherein excess ink is wiped off the printing cylinder prior to printing. The water-wipe solution contains the ink dispersed therein. Then, the ink-water mixture is neutralized so that the ink can be separated from the water.

**Summary of the Invention**

The present invention provides a process for application and cleanup of a lithographic ink comprising the steps of:

applying a water insoluble lithographic ink and an aqueous fountain solution to a lithographic printing plate in which said lithographic ink is oil based, is water insoluble at acid pH levels of less than 7.0, and the acid functional resin contained therein has an acid value in the range of 25 to 200;

cleaning said printing plate after printing to remove residual lithographic ink and fountain solution by applying an aqueous wash solution to said printing plate, said aqueous wash solution having a pH greater than 8,5;

removing said aqueous wash solution and residual lithographic ink and fountain solution from said printing plate to form a spent wash solution;

changing the pH of said spent wash solution to a pH of less than 6 to cause precipitation of the residual lithographic ink, and

removing said residual lithographic ink from said spent wash solution.

The "first pH level" referred to herein is the acid pH level of less than 7.0, the "second pH level" means the pH of the aqueous wash solution of greater than 8.5.

A step which is preliminary to the clean up or recovery steps is the application of the coating composition to a substrate. This is accomplished using various application or processing equipment and tools (hereinafter sometimes referred to as "application equipment" or "application equipment and tools"). The application is at a pH falling within the first pH levels at which the composition is generally water insoluble.

Following such application, the application equipment and tools are cleaned using an aqueous solution having a pH falling within the second pH levels at which the composition is water soluble or washable. This results in the composition dissolving in, or being rendered washable by, the aqueous wash solution. The cleaning and removal of the composition from the application equipment and tools can be aided with the use of shop towels, brushes and other cleaning aids. Completion of the cleaning step results in a spent wash solution containing dissolved or finely dispersed particles of the composition and shop towels, brushes or other cleaning aids also containing the aqueous wash solution and dissolved or finely dispersed coating composition.

Clean up of the spent wash containing dissolved or finely dispersed composition involves changing its pH to a pH falling within the first pH levels. Because the composition is generally water insoluble under these conditions, a solubility shift occurs. This causes the composition to become water insoluble. Once insoluble, the composition is no longer stable in the generally aqueous wash solution. As a result, the particles of such composition become hydrophobic or oleophillic, and begin to precipitate out and form larger particles of a filterable size as more and more of the contaminants contact each other and stick together. In addition, these particles have sufficient dimensional stability to facilitate separation by low cost separation technologies. Following this conversion of the coating composition to particles of a filterable size, they are removed from the spent wash solution either by conventional filtration or by centrifugation or other separation techniques known in the art.

Removing and recovering the composition from the shop towels and other cleaning aids involves first washing the same in a wash solution having a pH falling within the second pH levels or a conventional or modified laundering medium to remove the composition. This resulting wash solution or laundering medium is then treated as described above by changing the pH to a level corresponding to or falling within the first pH levels. This causes the dissolved or finely dispersed composition particles to precipitate out of solution and combine to produce particles of an adequate size capable of removal using conventional filtration or other separation techniques.

Accordingly, it is an object of the present invention to provide a method of cleaning waste water from a coating process in which the waste water comprises lithographic ink compositions.

These and other objects of the present invention will become apparent with reference to the description of the preferred method described below.

## DESCRIPTION OF THE PREFERRED METHOD

The present invention relates to a method of deaning waste water containing certain compositions or contaminants and a method of recovering such contaminants therefrom. More specifically, the present invention relates to a method of cleaning waste water containing compositions which contain water reducible resins or which are generally water insoluble at first pH levels and water soluble or water washable at second pH levels. Accordingly, those compositions to which the present invention is applicable are those coating compositions which, either themselves or because of their combination with other solubility controlling components, exhibit water solubility/insolubility behavior which is pH dependent.

It is contemplated that the method of the present invention is applicable to the clean up and/or recovery of oil based lithographic printing inks containing a water reducible resin to provide it with the desired pH dependent solubility.

As used herein, the term water reducible defines a property of a resin or composition which enables such resin or composition to be substantially water insoluble under certain conditions (preferably pH related) and capable of being or becoming water soluble or water washable or dispersible under certain other conditions (preferably pH related). In accordance with the preferred embodiment, the term water reducible defines a resin or composition whose water solubility behavior is pH dependent, with such resin or composition being water insoluble under acidic conditions and water washable under alkaline conditions.

The lithographic ink formulations to which the method of the present invention are applied comprise a variety of components or ingredients including a varnish or vehicle component, pigments, solvents or diluents and various additives. The pigments, solvents or diluents and additives provide the ink composition with certain desirable characteristics such as color, drying speed, tack, viscosity, etc. These may be considered optional, depending upon the particular characteristics desired. Pigments or coloring agents may include organic and inorganic pigments and dyes and other known colorants. Solvents or diluents are principally used to control viscosity, improve compatibility of other components, among others. Additives and other auxiliary components may include, for example, waxes, greases, plasticizers, stabilizers, drying agents, supplemental drying agents, thickeners, fillers, inhibitors and others known to the art.

The major component of a lithographic ink composition is commonly referred to in the industry as the lithographic ink varnish or vehicle. A lithographic ink varnish or vehicle comprises two principal components: a resin component and an oil or diluent component. As used herein, the term resin is used in its broadest sense to include all natural and synthetic resins capable of functioning as a component in a printing or printing ink environment. In the ink composition of the present invention, the varnish, and in particular the resin component, is formulated to provide the ink composition with the characteristic of being selectively water insoluble at certain pH levels and water soluble or washable at other pH levels.

Lithographic ink varnishes may be divided into two major classes depending upon the system of curing or drying the inks. The first system is an oleoresinous system which is generally used to produce quick set, heat set, and various other drying inks which set or dry by oxidation, absorption of the oil into the substrate, or solvent evaporation. The second system is known as an acrylic system which employs ultraviolet, electron beam or other radiation curing techniques. In an oleoresinous system, the vehicle is comprised of resins and oils or solvents; in radiation curable inks, these are replaced by polymerizable components such as acrylate functional oligomers and monomers known in the art. In a radiation curable system, the monomers are commonly referred to and function as diluents. The concept of the present invention is applicable to both systems; however, the preferred method is described with respect to an oleoresinous system.

The oil or diluent component of the ink composition or varnish of the preferred embodiment may be any one of a variety of oils or oil derivatives which are commonly used in the formulation of lithographic inks. Preferably these include, but are not necessarily limited to, vegetable and other oils such as linseed, soybean or soya, castor, dehydrated castor, corn, tung, carnuba and otticita oils. Certain petroleum distillates or mineral oils can also be used in combination with or in lieu of the vegetable oils. An example of such a petroleum distillate is a solvent known as a Magie solvent which is a napthenic hydrocarbon solvent. Fatty acids can also be used. Examples of suitable fatty acids include oleic, linoleic or tall oil fatty acids. The oil or diluent component of the ink composition or varnish functions principally to dissolve and act as a carrier for the resin component. Thus, a principal requirement of the oil component is that it be compatible with, and therefore able to dissolve or be miscible with, the resin component. Various oils and oil formulations which are usable in ink compositions and in particular lithographic ink compositions are well known in the art as disclosed for example in The Printing Ink Manual, Fourth Edition (1988) edited by R. H. Leach and published by Van Nostrand Reinhold, the substance of which is incorporated herein by reference. Preferably the oil or diluent component of the ink varnish should comprise about 10% to 90% by weight and most preferably about 30% to 70% by weight.

The resin component in a lithographic ink composition or varnish functions, among other things, as a film former to bind the varnish and pigment together and, when the ink dries, to bind the same to the receiving substrate. The resin component also contributes to the properties of hardness, gloss, adhesion and flexibility of an ink and must be compatible with the oil or diluent component of the varnish. In conventional oleoresinous systems, the resin component is commonly comprised of a first or hard resin component and a second resin component which typically is an alkyd or polyester resin, but which can comprise various other compositions and resins as well. Preferably the ink composition comprises a two resin component system; however, this is not a requirement.

For a two resin component system, the first or hard resins are normally solid at room temperatures, are water insoluble regardless of the pH of the solution to which they are exposed, and typically fall into two principal classes: the modified rosin ester resins and the modified hydrocarbon resins. Various hard resins or hard resin combinations or blends can be, and have been, utilized in the ink composition of the present invention providing such resins are compatible with each other, with the oil and with the alkyd, polyester or other resin components of the varnish. As used herein, compatibility means generally soluble or miscible with one another. Hard resins usable in lithographic inks of the present invention may be comprised of natural or processed resins such as rosins, rosin esters, maleic modified resins, rosin modified fumaric resins, dimerized and polymerized rosins, asphalts such as gilsonite and the like, phenolics, rosin modified phenolics, terpenes, polyamides, cyclised rubber, acrylics, hydrocarbons and modified hydrocarbons. Also included among the available resins are those identified in The Printing Ink Manual, supra, the substance of which is incorporated herein by reference.

The second resin component for a two resin component ink composition or varnish, like the hard resins, functions to form the varnish or ink composition into a cohesive material and, upon printing, bond the pigment to the receiving substrate. However, unlike the hard resins described above, this second resin component is typically not solid, but is a viscous liquid. Further, unlike resin components of conventional lithographic inks, this resin component is formulated or selected to be water reducible or to exhibit selective water solubility or washability behavior as a function of pH.

Although a two resin component system is preferred, a single resin component system can also be formulated. In the single resin component system, the entire resin component is comprised of a resin or combination of resins, all of which are water reducible or exhibit selective water solubility or washability as a function of pH. Thus, regardless of the type of resin system, the present invention preferably requires at least a portion of the resin component to include a resin whose water solubility or washability behavior is pH dependent.

Oil based compositions which contain water reducible resins or which exhibit the above described pH dependent water solubility behavior are those in which their acid functionality is sufficient to result in such behavior. The Acid Number of an acid functional resin is one measure of that particular resin to exhibit water reducible properties, (i. e.), the ability to be water insoluble at certain acidic pH levels and water soluble or washable at certain alkaline pH levels. The Acid Number at which a particular resin will exhibit water reducible behavior, however, varies from resin to resin. Some, such as certain alkyds, polyesters, polyolefins, epoxy esters, rosin derivatives and modified oils, will exhibit water reducible behavior at relatively low Acid Numbers in the range of about 25 to 200. Others, including certain modified rosins such as phenolics, maleics, fumaric and pentaerythritol esters, certain synthetic hydrocarbons as well as unmodified rosin and derivatives thereof, exhibit water reducible behavior only at relatively high Add Numbers greater than 200, if at all. Regardless of the particular type of resin, however, the Acid Number at which such resin exhibits water reducible behavior will depend on the particular formulation of that resin.

For ink compositions usable in the method of the present invention, the Acid Number of water reducible resin should preferably be sufficiently high to provide such resin with water reducible characteristics. This is at least 25 and more preferably about 30. However, since the Acid Number of a resin also impacts, to some extent, the compatibility of the resin with the oil or solvent component of the varnish and its stability with respect to aqueous fountain solutions, the water reducible resin, or at least a major portion of the water reducible resin, for lithographic compositions should preferably have an Acid Number sufficiently low to render it compatible with the oil component and to provide it with sufficient stability under acidic conditions to enable it to print lithographically. Although limited amounts of water reducible resins with high Acid Numbers (less than about 10% by weight of the varnish) can be tolerated, the major portion of the water reducible resin, for lithographic purposes, has an Acid Number less than 200 or in the range of 25 to 200. More preferably this Acid Number range should be less than about 150 and most preferably less than about 100. For ink compositions other than for a lithographic application, no upper limit for the Acid Number exists; however, the resin must have an Acid Number which causes it to exhibit water reducible behavior. In the case of alkyds, the Acid Number is reported for the entire molecule, including both the resin and oil portions combined.

The extent to which the composition is required to have a maximum Acid Number will depend upon the particular environment in which the method is practiced. In a lithographic printing environment, a maximum Acid Number is desirable because of the criticality of maintaining a stable separation between the oil and water components of a lithographic system. In contrast, for non lithographic ink compositions and for paints, varnishes and other coating compositions, no maximum Acid Number exists. In such cases, however, the Acid Number will, to some extent, dictate the efficiency with which the water solubility of the composition can be converted between a water soluble and a water insoluble form. In general, the greater the Acid Number, the more acid will be required to convert the composition to a water insoluble form.

In a lithographic printing environment, the oil based ink composition exhibits acid functionality defined by an Acid Number preferably in the range of 25 - 200, more preferably in the range of about 30 - 150 and most preferably in the range of about 40 - 100. Compositions with Acid Numbers below these ranges will tend to not exhibit the necessary pH dependent water solubility for practicing the present invention, while compositions with Acid Numbers above these ranges will tend to exhibit insufficient stability for lithographic printing. In all cases, the particular Acid Number which is preferred will depend on the particular composition being used.

The method of the present invention is applicable to compositions which themselves individually exhibit pH dependent water solubility/insolubility behavior as well as compositions which alone do not exhibit such behavior , but which when combined with certain solubility controlling components will exhibit at least limited water solubility or washability behavior as a function of pH.

It has been found that certain compositions, when combined with a sufficient quantity of a compatible solubility controlling component such as a water reducible alkyd, polyester or other resin, or a blend of such compounds, will result in the entire combined composition exhibiting pH dependent water solubility behavior sufficient to practice the method of the present invention. Preferably, the composition with which the method of the present invention is applicable should include at least 5% by weight, or about 5 - 60% by weight, of a solubility controlling component or water reducible resin which is water insoluble at certain first pH levels and water soluble or washable at certain second pH levels. More preferably, such solubility controlling component should be present in an amount of at least about 10% or about 10 - 40% by weight. It has been shown that certain water reducible alkyds (Cargill's short oil alkyds 74 - 7450, 74 - 7451; Cargill's long oil alkyd 74 - 7416; Cook Composites short oil alkyd 101210), certain water reducible polyesters (Cargill's polyester 72-7203), certain water reducible polyolefins (Cargill's modified polyolefin 73 - 7358), certain water reducible modified oils (Cargill's modified linseed oil 73 - 7319) and certain water reducible epoxy esters (Cook Composites styrenated epoxy ester 100453) exhibit the desired characteristics and are capable of providing the required pH dependent solubility to the system provided they are compatible with the other components of the oil based composition and are present in an amount sufficient to cause such other components to exhibit similar characteristics. All of the above water reducible resins except the 73 - 7319 and the 73 - 7358 are available in a solvent diluted form. For those resins in a solvent diluted form it is preferable that they be solvent stripped.

For the water reducible compositions or other solubility controlling components exhibiting water solubility which is pH dependent and for ink compositions or other coating compositions incorporating such compounds, water solubility or washability characteristics depend on the pH of the aqueous solution with which the material comes into contact. The first pH level at which the above mentioned solubility controlling components or the composition are water insoluble are acidic pH levels less than 7.0.

The method steps involved in the present invention include the preliminary step of applying the oil based coating or ink composition to a substrate at an application pH corresponding to or falling within the first pH levels described above. This is followed by removing the coating or ink composition from at least a portion of the application equipment and tools using shop towels, brushes or other cleaning aids and an aqueous wash solution having a solution pH falling within the second pH levels. This results in a spent wash. solution containing dissolved or finely dispersed particles of the oil based composition and soiled shop towels and other cleaning aids containing similar materials. Next, the pH of the spent wash solution or the resulting wash or laundering medium from the shop towel cleaning process is lowered to a precipitation pH corresponding to the first pH levels. This converts the composition to a water insoluble form and causes it to precipitate out and combine to form particles which are sufficiently large for separation. Such particles are then separated and recovered via filtration, centrifugation or other known separation techniques. The filtrate from the separation process is a dear aqueous liquid substantially free of any of the composition or other contaminants, while the filtered material is comprised substantially of the separated composition or other contaminants.

The preliminary application step is dependent upon the particular composition being used and the particular environment in which such composition is being applied. In a lithographic printing application, the oil based ink composition, together with an aqueous fountain solution, are applied to a lithographic printing plate via application rollers. The ink is then transferred either directly to an image receiving substrate or to an intermediate blanket cylinder which then subsequently transfers the ink to the receiving substrate. During this process, the entire print train including the application rollers, the print plate and the blanket is exposed to the oil based ink composition.

In other printing processes, either oil based or non oil based ink water insoluble compositions may be applied to a printing plate or the like, without an accompanying fountain solution, and thereafter transferred to an ink receiving substrate. Oil based or non oil based paints, varnishes and other coating compositions may also be applied to substrates using conventional application equipment and tools. Application may be via roller means as in lithographic printing or via spray, brush or other application techniques known in the art.

Regardless of the particular application environment, the application equipment and tools must be cleaned. In the lithographic printing application, all or part of the print train including the application rollers, the print.plate and the blanket must be thoroughly cleaned to accommodate a change in the printing plate and/or ink. This is accomplished by flushing or wiping the application equipment with, or otherwise exposing it to, an aqueous wash solution with a pH level corresponding to the second pH levels defined above. Such flushing or wiping should be continued until the entire ink train and/or the blanket are clean. In the preferred procedure, the aqueous wash solution is applied in a manner such that the wash solution is mixed with or milled into the oil based composition on the application equipment. In the lithographic printing application, the wash solution is applied to the front end rollers of the print train and then cycled for about 100 cycles. Such mixing can also be accomplished via brushing, wiping or other similar techniques. Preferably the surfaces of the application equipment are then wiped with a shop towel or the like to finally remove any remaining composition contaminant.

Because the aqueous wash solution is at a pH level corresponding to the second pH levels (i.e., above 8.5), the oil-based ink composition on the application equipment and tools becomes water soluble or water washable, thus facilitating its removal from the application equipment or tool surfaces. This is done either by the flushing action or by wiping such surfaces with a shop towel, brush or the like, or by both. For the lithographic printing application, this removal step produces a resulting spent wash solution containing dissolved or finely dispersed particles of the composition and soiled shop towels, brushes or other cleaning aids containing similar materials.

The particular efficiency of the removal or cleaning step in the lithographic printing application will depend upon various factors including, among others, the pH of the aqueous wash solution, the temperature of the wash solution, the amount of wash solution used and whether or not surfactants or other additives are used. In the preferred system, an increase in the pH of the wash solution will result in an increase in the speed with which the oil based composition will be removed from the surfaces and a decrease in the volume of wash solution which must be utilized. The pH of the wash solution to be greater than 8.5, or in the range of 8.5 - 14, and most preferably greater than about 10.5 or in the range of 10.5 - 13. Increase in temperature will also tend to increase the efficiency of the removal or cleaning step by speeding up the conversion of the ink composition to a water soluble form and thus removal from the equipment. However, it is contemplated that most of the removal or cleaning steps will be performed at or about ambient temperatures.

Various additives can also be used to alter, and in particular to improve, the efficiency of the removal or cleaning step. For example, the use of various surfactants, cosolvents and other additives common to the industry may be used as part of the wash solution. Selection of the appropriate surfactant will depend on the particular composition. Examples of surfactants which have been found to be useful with oil based lithographic ink compositions include a nonionic surfactant made by Mazer Chemical and sold under the trade name Mazawet 77, a nonionic surfactant made by Air Products and sold under the trade name Surfonyl 104 and a cationic surfactant made by PPG Industries and sold under the trade name M Quat. Various other nonionic, cationic and anionic surfactants may also be used.

While not necessary to the practice of the present invention, surfactants provide additional surface wetting and dispersion characteristics during the cleaning (or solubilization) step. Of equal importance is the fact that the surfactants do not interfere with, but in fact appear to aid, the water clean up (or insolubilization) step as described below. This appears to result from the ability of the surfactants to surround the growing particles as they are formed. This in turn enhances the filterability of the resulting mixture.

If desired, the removal step may also include preapplication to the equipment of a clean up composition which is compatible with the composition to be removed and whose water solubility is pH dependent. Initial application of clean up composition will react with the ink composition thereon and render the same more readily water soluble at certain pH levels. Such a clean up composition may include a solubility controlling component and can be applied directly or, because of viscosity or other reasons, can be combined with one or more diluents compatible therewith. Virtually any of the water reducible alkyds, polyesters or other resins can be used as the solubility controlling component for this purpose provided they are compatible with the composition to be cleaned and exhibit the desired pH dependent water solubility behavior. Diluents which include fatty acids (such as oleic and stearic acids), vegetable oils (such as soya, caster and linseed oils) and mineral oils may be used to reduce the viscosity of the solubility controlling component provided they are compatible both with the composition to be cleaned and the solubility controlling component. Thus, a precoating or preapplication, together with a mixing or milling in, of a compatible solubility controlling component or a clean up composition containing the same will improve the efficiency of the removal by reducing the amount of wash solution needed and the removal time.

Following removal of the oil based ink composition from the application equipment and tools as provided above, the composition exists as a dissolved portion, or as finely dispersed particles, within the spent wash solution. A portion of the removed oil based composition is also contained within the shop towels or other cleaning aids either as dissolved portions or as finely dispersed particles within the spent wash solution.

For that portion of the oil based composition existing in a dissolved or finely dispersed form within the spent wash solution, recovery of the composition involves first changing the pH of such spent wash solution to a pH corresponding to the first pH levels and then removing or recovering the composition by filtration, centrifugation or various other separation techniques known in the art.

In the preferred system, lowering the pH of the spent wash solution causes such composition to become water insoluble. This in turn causes the composition to precipitate out, thereby facilitating its separation by filtration, centrifugation or the like. Even compositions which normally exist as liquids are separated as discrete particles to further enhance the separation efficiency. The conversion to a water insoluble form also results in the precipitated particles having an affinity for one another so that agglomeration of particles occurs. This further improves the ability to separate the precipitated particles of the ink composition from the spent aqueous wash solution.

Both the rate and extent to which the composition comes out of solution or combines to form particles large enough to filter is dependent upon the amount of acid (or free protons) in the wash solution and thus the pH level to which the spent wash solution is lowered. This in turn is determined by the amount and strength of the particular acid being used and the Acid Number of the particular composition. During the process of lowering the pH, acid is consumed as it reacts with the acid functional groups to render it nonionic. At a pH of 6, the acid is relatively dilute and the chance for neutralization is reduced since the available acid is not in great supply. Thus, at a pH of 6, the extent of precipitation is diminished and the time for precipitation to occur is longer. As much as several hours may be required for the precipitation to reach its maximum levels. In contrast, if the pH of the spent wash solution is lowered to a pH of 2, excess acid is available and the conversion occurs to a greater extent and very rapidly, on the order of a few seconds to several minutes. Preferably, for complete precipitation and separation of the composition particles from the aqueous solution to occur, a pH below 5 or in the range of about 4 - 5 is preferred. At pH levels above 5, the rate of neutralization is slower, thereby resulting in incomplete separation. At pH levels below 4, excess acid is present. This will not necessarily improve the overall separation, but will speed up the process. Thus, below a pH level of 4, economic analysis will determine whether increased speed justifies the excess acid for a given application.

It has been shown that various additives can improve the conversion of the ink composition from a water soluble or washable form to a water insoluble form, and thus its precipitation. For example, certain salts, specifically sodium chloride and potassium chloride, have been shown to have such an effect. It is believed that this is due to the equilibrium shifting effect of the excess ions which reduces the ionic effect of the acid groups and shifts the solubility of the material down. The presence of a salt will not appreciably impact the ultimate extent of separation, but will tend to speed up the process.

After the pH of the spent wash solution has been lowered and the composition precipitated, such precipitated particles can be removed through various separation techniques such as filtration, centrifugation and the like which are known in the art. Filtration will normally be the most efficient separation technique which can be improved with the use of various filter aids known in the art. If the density difference between the particles and the water is sufficiently large, separation via centrifugation is also a viable alternative. It may also be desirable, in certain cases, to preconcentrate the contaminants in the wash solution (prior to lowering the pH) via reverse osmosis or other processes known in the art.

With respect to shop towels which contain portions of the ink composition, either in a dissolved or finely dispersed form as part of the spent wash solution, the separation and recovery of such composition is similar to the separation and recovery of the composition from the spent wash solution. However, a first step with respect to shop towels or other cleaning aids requires the removal of such composition from the shop towels themselves. This can be accomplished by washing, soaking or rinsing the shop towels in a washing pH solution falling within the second pH levels. An alternate procedure is to launder the shop towels in a conventional or modified manner using conventional or modified laundering detergents or other compositions for the purpose of cleaning the composition from the towels. In both situations, the ink composition ends up as dissolved or finely dispersed particles in the wash or laundry solutions. Following this removal or cleaning procedure, the resulting spent wash or laundry solution is treated in a manner similar to that described above by changing the pH to a level corresponding to the first pH level. When this is done, the previously dissolved or finely dispersed ink composition will become insoluble. This in turn causes the composition to precipitate out and combine with one another to form into larger particles capable of separation by filtration or the like.

In a conventional or modified laundering process which normally includes the presence of surfactants and detergents, such materials actually improve the precipitation process. During the conversion of the composition from a water soluble to a water insoluble form, such surfactants and detergents surround the particles and maintain them as discrete particles. This promotes larger particles and easier separation.

Having described the details of the preferred method, the following examples will demonstrate the applicability of the method of the present invention to a wide range of compositions and to various mixtures and materials generated during a clean up process. Throughout the application, and in the examples, percentages are based upon weight unless otherwise indicated. Further, in certain examples where the water reducible alkyd or other resin is provided in a solvent diluted form, the resin was first solvent stripped to remove petroleum or other solvents.

**Procedure of Examples 1-6**

Examples 1 - 6 below were conducted to show application of the method of the present invention to an oil based lithographic ink composition (hereinafter referred to as Deluxe Ink #H32) having the following composition:

| | |
|---|---|
| Rosin (Arizona Chemical SLYVAROS R) | 30.14% |
| Alkyd (Cargill 74-7451) AN 47-53 | 13.80% |
| Castor Oil (USP-United Catalyst) | 15.53% |
| Oleic Acid (EMERSOL 213 NF, Henkel Inc.) | 15.53% |
| Black Pigment (REGAL 400R, Cabot Inc.) | 25.00% |

The above ink composition is an oil based ink composition exhibiting water solubility/insolubility behavior as a function of pH. Specifically, such composition is water insoluble at acidic pH levels below 7.0 and is water soluble or washable at alkaline pH levels and preferably pH levels above 8.5. The alkyd is a commercially available, water reducible short oil alkyd which has been solvent stripped.

In each of Examples 1 - 6, an aqueous waste water or spent wash solution was simulated and produced by combining known quantities of the above ink composition in a known quantity of an alkaline wash solution containing NaOH at a pH of 12.7. This was mixed with an impeller for about five minutes to achieve complete dispersion A standard Buchner funnel was fitted to a one liter filter flask and the flask was attached to a vacuum. Standard Whatman #2 filter paper was added to the Buchner funnel. In examples 1-5, 54g of Hyflo Super-Cel filter aid was added to the funnel to complete the filter apparatus. In example 6, 54g of the filter aid was added to 1 liter of the mixture. Following pretreatment by addition of an add as set forth in Examples 2 - 6, but without pretreatment as provided in Example 1, each of the samples was passed once through the filter apparatus described above, under vacuum, and the filtrate was collected for analysis. Pretreatment with acid included adding the add over a period of about 30 seconds until the desired pH was reached. Analysis of oils, greases and fats in the filtrate after separation was conducted using USEPA Method 413.1. Color evaluation of filtrate was conducted using visual qualitative analysis. Theoretical ink concentration and separation were calculated.

**Example 1 (No Pretreatment)**

| Waste water sample | 0.1066% ink in solution at pH of 12.7 |
| --- | --- |
| Ink concentration | 1066 mg/l |
| Pretreatment | None |
| Filtrate analysis | No effective separation |
| Oils, greases, fats analysis | 633.7 mg/l |
| Color | Dense black |
| Theoretical separation | $\frac{.75(1066) - 633.7}{.75(1066)} = 20.7\%$ |

**Example 2 (Pretreatment by pH reduction)**

| Waste water sample | .1066% ink in solution at pH 12.7 |
| --- | --- |
| Ink concentration | 1066 mg/l |
| Pretreatments | Addition of concentrated HCl to pH 2 |
| Filtrate analysis | Effective separation |
| Oil, greases, fats | 2.6 mg/l |
| Color | Clear |
| Theoretical separation | $\frac{.75(1066)-2.6}{.75(1066)} = 99.6\%$ |

**Example 3 (Pretreatment by pH reduction and high ink concentration)**

| Waste water sample | 1.000% ink in solution at pH 12.7 |
| --- | --- |
| Ink concentration | 10,000 mg/l |
| Pretreatment | Addition of concentrated HCl to pH 3.4 |
| Filtrate analysis | Effective separation |
| Oils, greases, fats | 25.0 mg/l |
| Color | Clear |
| Theoretical separation | $\frac{.75(10.000)-25}{.75(10,000)} = 99.6\%$ |

**Example 4 (Drop pH to 6.0)**

| Waste water sample | 1.000% ink in solution at pH 12.7 |
| --- | --- |
| Ink concentration | 10,000 mg/l |
| Pretreatment | Addition of concentrated HCl to pH 6.0 |
| Filtrate analysis | Partial separation |
| Oils, greases, fats | 863 mg/l |

(continued)

| Color | Slightly pigmented |
|---|---|
| Theoretical separation | $\frac{.75(10,000) - 863}{.75(10,000)} = 88\%$ |

## Example 5 (Drop pH to 6.0 and add 5% KCl)

| Waste water sample | 1.000% ink in solution at pH 12.7 |
|---|---|
| Pretreatment | Add concentrated HCl to bring pH to 6. Also add 5% KCl to speed separation. |
| Filtrate analysis | Partial separation |
| Oils, greases, fats | 506 mg/l |
| Color | Very slightly pigmented |
| Theoretical separation | $\frac{.75(10,000) - 506}{.75(10,000)} = 93\%$ |

## Example 6 (Pretreatment by pH reduction and preaddition of filteraid)

| Waste water sample | 1.000% ink in solution at pH 12.7 |
|---|---|
| Ink concentration | 10,000 mg/l |
| Pretreatment | Addition of concentrated $H_2SO_4$ to pH 4.0 |
| Filtrate analysis | Effective separation |
| Oils, greases, fats | 33 mg/l |
| Color | Clear |
| Theoretical separation | $\frac{.75(10,000) - 33}{.75(10,000)} = 99.5\%$ |

Example 1 demonstrated no effective separation of the ink from the waste water by the filtration procedure. Because of the USEPA Method 413.1 procedure used, a prefiltering step was performed on all samples. During the prefilter step, a certain amount of pigment, with absorbed oil, is trapped and removed from the system. Thus, the 20.7% theoretical separation for example 1 is misleading because much of the contaminant was removed as part of this procedure, not as part of the initial separation. In reality, little, if any, of the oils, fats, and greases would be removed during the filtering step if USEPA Method 413.1 procedure is not performed. The result of Examples 2, 3 and 6 demonstrated effective separation and recovery, while Examples 4 and 5 demonstrated partial separation and recovery.

## Examples 7-11

The procedure of Examples 7-11 was similar to that of Examples 1-6, but different ink and other coating compositions were tested. The details are as follows:

## Example 7

In Example 7, the Deluxe #H32 ink composition identified in Examples 1-6 was mixed in a 5:1 ratio (Deluxe #H32: Multigraphic PS-274) with conventional oil based lithographic ink identified as Multigraphic PS-274 made by AM Multigraphic. This lithographic ink did not exhibit water solubility/insolubility behavior as a function of pH.

| Waste water sample | 1.010% ink in solution at pH 12.7 |
|---|---|
| Ink concentration | 10100 mg/l |
| Pretreatment | Add concentrate HCl to pH 4.0 |
| Filtrate analysis | Complete separation |
| Oils, greases, fats | 33mg/l |
| Color | Clear |
| Theoretical separation | $\frac{.75(10.000) - 33}{.75(10,000)} = 99.6\%$ |

### Example 8

In Example 8, the composition used was a water-based latex enamel identified as a Glidden Ultra Hide low lustre enamel exhibiting water solubility behavior as a function of pH.

| | |
|---|---|
| Waste water sample | Enamel paint at 1.038% in solution at pH 12.7 |
| Paint concentration | 10380 mg/l |
| Pretreatment | Treat with concentrated HCl to pH 2.1 |
| Filtrate analysis | Complete separation |
| Oils, greases, fats | 194 mg/l |
| Color | Clear |
| Note: Theoretical separation unknown due to no knowledge of paint formula. | |

### Example 9

Example 9 involved a Handschy water-based black flexo ink identified by the tradename Hanco #50688 exhibiting water solubility as a function of pH.

| | |
|---|---|
| Waste water sample | 1.005% ink in solution at pH 12.7 |
| Ink concentration | 10050 mg/l |
| Pretreatment | Treat with concentrated HCl to pH 2.1 |
| Filtrate analysis | Complete separation |
| Oils, greases, fats | 37 mg/l |
| Color | Clear, slight blue tint |
| Note: Theoretical separation unknown due to no knowledge of ink formula | |

### Example 10

Example 10 involved tests conducted on the dear varnish of the Deluxe #H32 ink composition identified in Examples 1-6, with pigments deleted.

| | |
|---|---|
| Waste water sample | 1.016% clear varnish in solution at pH 12.7 |
| Varnish concentration | 10160 mg/l |
| Pretreatment | Treat with concentrated HCl to pH 2.05 |
| Filtrate analysis | Complete separation |
| Oils, greases, fats | 52 mg/l |
| Color | Clear |
| Theoretical separation | $\frac{10160 - 52}{10160} = 99.58\%$ |

### Examples 11 - 29

In Examples 11 - 29 specific ink formulations exhibiting water solubility/insolubility behavior as a function of pH were tested for their ability to be cleaned and recovered in accordance with the present invention. The ink compositions were prepared by cooking the varnish comprised of the resins and oil at a temperature and for a sufficient period to melt the hard resin and cause the oil to dissolve the hard resin and the water reducible resin. The pigment was then added and milled on a laboratory scale three roll mill to adequately disperse the pigment. Print tests were conducted on an A.B. Dick 375 offset duplicator fitted with a Dahlgren Chem-Series dampener. Plates were Kodak (Product Code 2984) aluminum and the fountain solution used was Rosos KSP#10 ASM2, with a working strength pH of 5.2. The paper used was Nekoosa 24# Arbor bond white. Print densities were measured using an X-Rite model 418 color densitometer. The press was run for 300 impressions and stopped every 100 impressions, at which time the blanket was acceptably cleaned using water adjusted to pH 13 using sodium hydroxide. At the conclusion of the press test, the rollers were acceptably cleaned using water adjusted to pH 13 using sodium hydroxide. The print quality including print density, edge definition and permanency were acceptable.

For all compositions of Examples 11-29, 10,000 mg of the ink composition was also combined with one liter of a NaOH solution adjusted to a pH of 12.7. Each sample was pretreated with concentrated hydrochloric acid to a pH of about 2.0. In all samples, a noticeable precipitation was observed upon addition of the acid. The resulting mixture was filtered in accordance with the procedure described in Examples 1-6. In all instances, the filtrate was determined by visual observation to be a dear liquid with no noticeable traces of the ink composition.

Example 11: Process Black

| | |
|---|---|
| Technical Grade Rosin (EM Science RX0170) | 33% |
| Alkyd (Cargill 074-7451) AN 47-53 | 17% |
| Castor Oil (United Catalyst USP) | 37% |
| Carbon Black (Cabot Regal 400R) | 13% |
| Print density: 1.6 | |

Example 12: Process Cyan

| | |
|---|---|
| Technical Grade Rosin (EM Science RX0170) | 36% |
| Alkyd (Cargill 074-7451) AN 47-53 | 18% |
| Castor Oil (United Catalyst USP) | 36% |
| Blue 15:3 (Uhlich color #B1-0500) | 10% |
| Print density: 1.0 | |

Example 13: Process Magenta

| | |
|---|---|
| Technical Grade Rosin (EM Science RX0170) | 31% |
| Alkyd (Cargill 074-7451) AN 47-53 | 17% |
| Castor oil (United Catalyst USP) | 37% |
| Red 81 (Uhlich color (RD-1143) | 15% |
| Print density: 1.2 | |

Example 14: Process Yellow

| | |
|---|---|
| Technical Grade Rosin (EM Science RX0170) | 37% |
| Alkyd (Cargill 074-7451) AN 47-53 | 17% |
| Castor oil (United Catalyst USP) | 36% |
| Yellow 12 (Uhlich color #YE-0150) | 10% |
| Print Density: .9 | |

Example 15:

Varnish Cook

| | |
|---|---|
| Temperature: 330°F (166°C) | |
| Maleic ester modified rosin (Unirez 7003 - Union Camp Co.) | 29% |

(continued)

| Alkyd (Cargill 074-7451) AN 47-53 | 16% |
| Castor Oil (United Catalyst USP) | 15% |
| Oleic Acid (Emersol 213 NF, Henkel Co.) | 27% |
| Carbon Black (Cabot Regal 400R) | 13% |

Example 16:

Varnish Cook

| Temperature: 235°F (113°C) | |
| Pentaerythritol ester of rosin (Unitac R-100, Union Camp Co.) | 31% |
| Alkyd (Cargill 074-7451) AN 47-53 | 17% |
| Castor Oil (United Catalyst USP) | 16% |
| Oleic Acid (Emersol 213 NF, Henkel Inc.) | 23% |
| Carbon Black (Cabot Regal 400R) | 13% |

Example 17:

Varnish Cook

| Temperature 330°F (166°C) | |
| Fumaric acid rosin (Unirez 8200 - Union Camp Co.) | 26% |
| Alkyd (Cargill 074-7451) AN 47-53 | 14% |
| Castor Oil (United Catalyst USP) | 15% |
| Oleic Acid (Emersol 213 NF, Henkel Inc.) | 32% |
| Carbon Black (Cabot Regal 400R) | 13% |

Example 18:

Varnish Cook

| Temperature: 265°F (129°C) | |
| Phenolic modified rosin ester (Uni-Rez 9266, Union Camp) | 23% |
| Modified Linseed Oil (Cargill 73-7319) AN 95-105 | 17% |
| Linseed Oil (Degen Oil OGN/04-14) | 25% |
| Oleic Acid (Emersol 213 NF, Henkel Co.) | 22% |
| Carbon Black (Cabot Regal 400R) | 13% |

Example 19

Varnish Cook

| Temperature: 320°F (160°C) | |
| Nevroz 1520 | 34% |

(continued)

| | |
|---|---|
| Magie Solvent 60 | 17% |
| Vista Solvent 47 (Vista Chem.) | 17% |
| Modified Linseed Oil (Cargill 073-7319) AN 95-105 | 19% |
| Carbon Black (Cabot Regal 400R) | 13% |

Example 20:

Varnish Cook

| | |
|---|---|
| Temperature: 200°F (93°C) | |
| Rosin (EM Science RX0170) | 36% |
| Modified Linseed Oil (Cargill 073-7319) AN 95-105 | 16% |
| Linseed Oil (Degen Oil CGN/04-14) | 18% |
| Oleic Acid (Emersol 213NF, Henkel Co.) | 17% |
| Carbon Black (Cabot Regal 400R) | 13% |

Example 21:

Varnish Cook

| | |
|---|---|
| Temperature: 200°F (93°C) | |
| Rosin (EM Science RX0170) | 36% |
| Modified Linseed Oil (Cargill 073-7319) AN 95-105 | 16% |
| Soybean Oil (Continental Mills Con32-00) | 17% |
| Oleic Acid (Emersol 213 NF, Henkel Co.) | 18% |
| Carbon Black (Cabot Regal 400R) | 13% |

Example 22:

Varnish Cook

| | |
|---|---|
| Temperature: 200°F (93°C) | |
| Rosin (EM Science RX0170) | 36% |
| Modified Linseed Oil (Cargill 073-7319) AN 95-105 | 16% |
| Linseed Oil (Degen oil OGN/04-14) | 17% |
| Magiesol 47 (Magie Oil Co.) | 17% |
| Carbon Black (Cabot Regal 400R) | 13% |

Example 23:

Varnish Cook

| | |
|---|---|
| Temperature: 320°F (160°C) | |
| Nevroz 1520 (Neville Chem) | 16% |

(continued)

| Rosin (EM Science RX0170) | 26% |
|---|---|
| Vista Sol 47 (Vista Chem) | 28% |
| Modified Linseed Oil (Cargill 073-7319) AN 95-105 | 17% |
| Carbon Black (Cabot Regal 400R) | 13% |

Example 24:

Varnish Cook

| Temperature: 320°F (160°C) | |
|---|---|
| Maleic ester modified rosin (Unirez 7003, Union Camp Co.) | 35% |
| Polyester (Cargill 072-7203) AN 50-60 | 16% |
| Castor Oil (United Catalyst USP) | 18% |
| Oleic Acid (Emersol 213 NF Henkel Co.) | 18% |
| Carbon Black (Cabot Regal 400R) | 13% |

Example 25:

Varnish Cook

| Temperature: 200°F (93°C) | |
|---|---|
| Rosin (EM Science RX0170) | 35% |
| Short Oil Alkyd (Cargill 074-7450) AN 47-53 | 16% |
| Castor Oil (US Catalyst USP) | 18% |
| Oleic Acid (Emersol 213NF, Henkel) | 18% |
| Carbon Black (Regal 400R, Cabot) | 13% |

Example 26:

Varnish Cook

| Temperature: 235°F (113°C) | |
|---|---|
| Pentaerythritol ester of rosin (Unitac R-100, Union Camp) | 27% |
| Modified Polyolefin (Cargill 073-7358) AN 25-30 | 20% |
| Linseed Oil | 24% |
| Oleic Acid (Emersol 213NF, Henkel) | 16% |
| Carbon Black (Regal 400R, Cabot) | 13% |

Example 27:

Varnish Cook

| Temperature: 200°F (93°C) | |
|---|---|
| Rosin (EM Science RX0170) | 35% |

(continued)

| Long Oil Alkyd (Cargill 074-7416) AN 53-58 | 23% |
|---|---|
| Castor Oil (US Catalyst USP) | 14% |
| Oleic Acid (Emersol 213NF, Henkel) | 15% |
| Carbon Black (Regal 400R, Cabot) | 13% |

Example 28:

Varnish Cook

| Temperature: 200°F (93°C) | |
|---|---|
| Rosin (EM Science RX0170) | 35% |
| Styrenate Epoxy Ester (Chempol 10-0453, Cook Composites) AN 65 | 23% |
| Castor Oil (US Catalyst USP) | 14% |
| Oleic Acid (Emersol 213NF, Henkel) | 15% |
| Carbon Black (Regal 400R, Cabot) | 13% |

Example 29:

Varnish Cook

| Temperature: 200°F (93°C) | |
|---|---|
| Rosin (EM Science RX0170) | 37% |
| Short Oil Alkyd (Chempol 10-1210, Cook Composites) AN 32 | 23% |
| Castor Oil (US Catalyst USP) | 14% |
| Oleic Acid (Emersol 213NF, Henkel) | 15% |
| Carbon Black (Regal 400R, Cabot) | 13% |

**Examples 30 - 37**

Lithographic ink (Deluxe #H32) was applied to the rollers of an A.B. Dick 375 offset lithographic press until a consistent film of .007 inch was measured using an ink film thickness gauge.

In Examples 30 - 36, 10 milliliters of a solution of a preapplication clean up composition comprised of 10% by weight of a solubility controlling component (SCC), 87% by weight of a diluent (either oleic acid or castor oil) and 3% by weight of surfactant was applied to the rollers and allowed to mill in to the ink train for 100 press revolutions. A washup tray was then fitted on the press and the press rollers started. An aqueous wash solution of water/sodium metasilicate adjusted to pH 12.5 was sprayed on the rotating rollers until all ink was removed. A stopwatch was used to time the entire operation from the time where the wash up blade was attached to the press.

The test of Example 37 involved the evaluation of press clean up without the above preapplication solution. In Example 37, the exact procedure above was followed except the aqueous solution at pH 12.5 replaced the preapplication solution.

| Ex # | SCC | Diluent | Surfactant | %SCC | Result | Time (min.) |
|---|---|---|---|---|---|---|
| 30 | 74-7416 | Oleic Acid | Mazawet 77 | 10 | Clean | 4:30 |
| 31 | 74-7495 | Oleic Acid | Mazawet 77 | 10 | Clean | 4:10 |
| 32 | 73-7358 | Oleic Acid | Mazawet 77 | 10 | Clean | 3:40 |
| 33 | 10-1210 | Oleic Acid | Mazawet 77 | 10 | Clean | 3:45 |
| 34 | 10-0453 | Oleic Acid | Mazawet 77 | 10 | Clean | 3:25 |
| 35 | 74-7451 | Oleic Acid | Mazawet 77 | 10 | Clean | 3:50 |

(continued)

| Ex # | SCC | Diluent | Surfactant | %SCC | Result | Time (min.) |
|---|---|---|---|---|---|---|
| 36 | 74-7451 | Castor Oil/ Oleic Acid | Mazawet 77 | 10 | Clean | 3:45 |
| 37 | - | - | - | - | Clean | 5:40 |

In the above examples, 74-7416 is a Cargill water reducible long oil alkyd (AN 53-58); 74-7495 is a Cargill water reducible chain stopped alkyd (AN 33-38); 73-7358 is a Cargill water reducible modified polyolefin (AN 25-30); 10-1210 is a Cook Composite water reducible short oil alkyd (AN 32); 10-0453 is a Cook Composite water reducible styrenate epoxy ester (AN 65) and 74-7451 is a Cargill water reducible short oil alkyd (AN 47-53).

The table above illustrates a reduction of cleaning times of about 20% - 40% with the use of a preapplication clean up composition.

## Example 38

Shop towels soiled with Deluxe #H32 ink were placed in an alkaline water bath at room temperature. One liter of water was used and the soiled towels were agitated for five minutes. The dirty water was drained and the shop towels wrung out. One liter of tap water was introduced (at room temperature) and the towels were agitated for another five minutes. The rinse water was collected. An additional rinse cycle was used and the resulting towels were clean.

The collected water (including both the wash and rinse) was then lowered to a pH of 3.0 using hydrochloric acid and filtered though a Whatman #2 filter. Clear filtrate was obtained.

## Example 39

The procedure in Example 38 was followed except 10 gm of Surf laundry detergent was added per liter of wash water. Again clean towels resulted and the waste water was successfully treated.

## Claims

1.   A process for application and cleanup of a lithographic ink comprising the steps of:

applying a water insoluble lithographic ink and an aqueous fountain solution to a lithographic printing plate in which said lithographic ink is oil based, is water insoluble at acid pH levels of less than 7.0, and the acid functional resin contained therein has an acid value in the range of 25 to 200;

cleaning said printing plate after printing to remove residual lithographic ink and fountain solution by applying an aqueous wash solution to said printing plate, said aqueous wash solution having a pH greater than 8,5;

removing said aqueous wash solution and residual lithographic ink and fountain solution from said printing plate to form a spent wash solution;

changing the pH of said spent wash solution to a pH of less than 6 to cause precipitation of the residual lithographic ink, and

removing said residual lithographic ink from said spent wash solution.

2.   The process of claim 1 wherein said wash solution is a laundering medium.

3.   The process of any preceding claim wherein said lithographic ink component is removed from said spent wash solution by filtration.

4.   The process of any preceding claim including the step of adding salt to the spent wash solution to assist in the precipitation of said residual lithographic ink.

5.   The process of claim 1 wherein the pH of said aqueous wash solution is greater than about 10.5.

6.   The process of claim 1 wherein the changing step includes changing the pH of said spent wash solution to a pH of less than 5.

**Patentansprüche**

1.  Verfahren zum Auftragen und Aufwaschen einer Lithographiefarbe, welches folgende Schritte umfasst:

    Auftragen einer wasserunlöslichen Lithographiefarbe und einer wässrigen Fontänenlösung auf eine lithographische Druckplatte, wobei die Lithographiefarbe auf Ölbasis ist, bei sauren pH-Werten von weniger als 7,0 in Wasser unlöslich ist und das darin enthaltene säurefunktionelle Harz eine Säurezahl im Bereich von 25 bis 200 hat,
    Reinigen der Druckplatte nach dem Druck, um zurückgebliebene Lithographiefarbe und Fontänenlösung zu entfernen, indem eine wässrige Waschlösung auf die Druckplatte aufgebracht wird, welche einen pH-Wert von mehr als 8,5 hat,
    Entfernen der wässrigen Waschlösung und der zurückgebliebenen Lithographiefarbe und Fontänenlösung von der Druckplatte unter Bildung einer verbrauchten Waschlösung,
    Ändern des pH-Werts der verbrauchten Waschlösung in einen pH von weniger als 6, um die Ausfällung der zurückgebliebenen Lithographiefarbe zu verursachen, und
    Entfernen der zurückgebliebenen Lithograpiefarbe aus der verbrauchten Waschlösung.

2.  Verfahren nach Anspruch 1, wobei die Waschlösung ein Waschmedium ist.

3.  Verfahren nach einem der vorhergehenden Patentansprüche, wobei die Lithographiefarbe durch Filtration aus der verbrauchten Waschlösung entfernt wird.

4.  Verfahren nach einem der vorhergehenden Patentansprüche, welches den Schritt der Zugabe von Salz zu der verbrauchten Waschlösung umfasst, um die Ausfällung der zurückgebliebenen Lithographiefarbe zu fördern.

5.  Verfahren nach Anspruch 1, wobei der pH-Wert der wässrigen Waschlösung höher als etwa 10,5 ist.

6.  Verfahren nach Anspruch 1, wobei der Schritt des Änderns die Änderung des pH-Werts der verbrauchten Waschlösung in einen pH-Wert von weniger als 5 umfasst.


**Revendications**

1.  Procédé pour l'application et l'élimination d'une encre lithographique, comprenant les étapes consistant :

    à appliquer une encre lithographique insoluble dans l'eau et une solution de mouillage aqueuse sur une plaque d'impression lithographique, dans laquelle ladite encre lithographique est à base d'huile, est insoluble dans l'eau à des niveaux de pH acides inférieurs à 7,0, et la résine à fonctionnalité acide contenue dans celle-ci a un indice d'acide dans la gamme de 25 à 200 ;
    à nettoyer ladite plaque d'impression après l'impression pour éliminer l'encre lithographique résiduelle et la solution de mouillage en appliquant une solution de lavage aqueuse sur ladite plaque d'impression, ladite solution de lavage aqueuse ayant un pH supérieur à 8,5 ;
    à éliminer lesdites solution de lavage aqueuse et encre lithographique résiduelle et solution de mouillage de ladite plaque d'impression pour former une solution de lavage épuisée ;
    à changer le pH de ladite solution de lavage épuisée à un pH inférieur à 6 pour provoquer la précipitation de l'encre lithographique résiduelle, et
    à éliminer ladite encre lithographique résiduelle de ladite solution de lavage épuisée.

2.  Procédé selon la revendication 1, dans lequel ladite solution de lavage est un milieu de blanchissage.

3.  Procédé selon l'une quelconque des revendications précédentes, dans lequel ledit constituant encre lithographique est éliminé de ladite solution de lavage épuisée par filtration.

4.  Procédé selon l'une quelconque des revendications précédentes, incluant l'étape consistant à ajouter un sel à la solution de lavage épuisée pour faciliter la précipitation de ladite encre lithographique résiduelle.

5.  Procédé selon la revendication 1, dans lequel le pH de ladite solution de lavage aqueuse est supérieur à environ 10,5.

6. Procédé selon la revendication 1, dans lequel l'étape de changement comprend le changement du pH de ladite solution de lavage épuisée à un pH inférieur à 5.